**Europäisches Patentamt**

**European Patent Office**

**Office européen des brevets**

(19)

(11) Veröffentlichungsnummer: **0 019 185**
A2

(12) ## EUROPÄISCHE PATENTANMELDUNG

(21) Anmeldenummer: 80102437.3

(22) Anmeldetag: 05.05.80

(51) Int. Cl.³: **H 03 H 9/05**
**H 03 H 9/10**

(30) Priorität: 10.05.79 DE 2918952

(43) Veröffentlichungstag der Anmeldung:
26.11.80 Patentblatt 80 24

(84) Benannte Vertragsstaaten:
AT BE CH DE FR GB IT LI NL SE

(71) Anmelder: SIEMENS AKTIENGESELLSCHAFT Berlin
und München
Postfach 22 02 61
D-8000 München 22(DE)

(72) Erfinder: Kinzel, Hermann
Grabmannstrasse 2
D-8000 München 71(DE)

(72) Erfinder: Katsch, Peter
Kemptener Strasse 37
D-8000 München 71(DE)

(54) Elektrisches Bauelement.

(57) Je ein mittleres Anschlußelement einer jeden der beiden Reihen von Anschlußelementen eines IC-Bauelementes ist derart abgewinkelt ausgebildet, daß es unmittelbar als Halteorgan für einen plattenförmigen Resonator dient. Mit den Enden anderer, vorzugsweise spinnenförmig nach außen geführter Anschlußelemente ist das IC-Bauelement mit den Stirnseiten von Anschlußstiften verlötet, die eine Bodenplatte durchdringen. Auf die Bodenplatte ist eine Gehäusekappe aufgesetzt. Auf diese Weise wird ein weitgehend durch automatisierbare Fertigungsschritte herstellbarer Oszillatorbaustein erhalten.

FIG 1

EP 0 019 185 A2

SIEMENS AKTIENGESELLSCHAFT      Unser Zeichen:
Berlin und München      VPA    79 P 6 5 8 3 EUR

## Elektrisches Bauelement

Die Erfindung bezieht sich auf ein elektrisches Bauelement mit wenigstens einem in integrierter Schaltungstechnik auf einem Substrat angeordneten Schaltkreis, der in einem im wesentlichen prismatischen Gehäuse angeordnet ist und bei dem an den Längsseiten des Gehäuses je eine Reihe von streifenförmigen Anschlußelementen, die mit dem Schaltkreis verbunden sind, aus dem Gehäuse herausgeführt sind.

Derartige Bauelemente sind schon seit langem bekannt. Sie enthalten in einem meist aus Kunststoff oder Keramik bestehenden länglichen plattenförmigen Gehäuse eine oder mehrere integrierte Schaltungen. Die an den Längsseiten des Gehäuses aus diesem austretenden Anschlußelemente sind rechtwinklig zu den großen Oberflächen des IC-Gehäuses abgewinkelt und bilden auf diese Weise mit ihren freien Enden in die Rasterbohrungen einer Leiterplatte einsteckbare Anschlußorgane.

Rt 1 Sse − 10.5.1979

Solche IC-Bauelemente können z.B. mit einem Resonator zu einer Oszillatorschaltung, deren Schwingfrequenz durch den Resonator stabilisiert ist, zusammengeschaltet werden.

Ein zu diesem Zweck verwendeter Resonator arbeitet meist als Dickenscherungsschwinger und wird durch eine relativ dünne Quarzplatte realisiert. Zum Anschluß und zur Halterung einer solchen Resonatorplatte sind aber besondere Vorkehrungen erforderlich.

Aufgabe vorliegender Erfindung ist es daher, ein elektrisches Bauelement der eingangs genannten Art so weiterzubilden, daß es auf unkomplizierte Weise mit einem plattenförmigen Resonator zu einem Verbundbaustein vereinigt werden kann.

Erfindungsgemäß ergibt sich die Lösung dieser Aufgabe dadurch, daß je ein mittleres Anschlußelement jeder Längsseite derart abgewinkelt ausgebildet ist, daß ein mit im wesentlichen einander gegenüberliegenden Randstellen in jeweils eine durch die Abwinkelungen gebildete U-förmige Aufnahmekontur eingefügter plattenförmiger Resonator in definiertem Abstand vom IC-Gehäuse unmittelbar von den beiden Anschlußelementen erfaßt und gehalten wird.

Auf diese Weise werden vorteilhaft zwei einander oder annähernd einander gegenüberliegende Anschlußelemente des IC-Bauelementes zu Halte- und Anschlußorganen des Resonators umfunktioniert, so daß der Resonator auf besonders einfache Weise mit dem IC-Bauelement verbunden werden kann, das die mit dem Resonator zusammenarbeitende in integrierter Technik ausgebildete Oszillatorschaltung enthält.

Weitere Ausgestaltungen der Erfindung sehen vor, daß der Resonator mit seinen großen Oberflächen parallel zu den beiden großen Oberflächen des ebenfalls plattenförmigen IC-Gehäuses und konzentrisch zu diesem angeordnet ist und daß zumindest einige der übrigen Anschlußelemente parallel zu den großen Oberflächen des IC-Gehäuses ausgerichtet sind und daß das IC-Gehäuse mit den Enden dieser Anschlußelemente auf die Stirnflächen von Anschlußstiften aufgesetzt und mit diesen Anschlußstiften verbunden ist, die rechtwinklig zu den großen Oberflächen des IC-Gehäuses ein Bodenstück durchdringen und in diesem verankert sind.

Durch diese Maßnahmen wird einerseits eine besonders raumsparende Zuordnung von Resonator und IC-Bauelement geschaffen und andererseits der aus dem Resonator und dem IC-Bauelement bestehende Verbundbaustein gemeinsam äußerst einfach in einem Gehäuse angeordnet, das erforderlich ist, um den Resonator vor Umwelteinflüssen zu schützen.

Schließlich ist im Rahmen der Erfindung noch vorgesehen, daß der Resonator auf der vom Bodenstück abgewandten Seite des IC-Gehäuses angeordnet ist.

Durch diese Anordnung des Resonators kann dieser auch noch nach der Verbindung des IC-Bauelementes mit dem Bodenstück des Resonatorgehäuses in die zu seiner Halterung und zu seinem Anschluß vorgesehenen Anschlußelemente des IC-Bauelementes eingesetzt werden.

Nachfolgend wird ein Ausführungsbeispiel der Erfindung anhand von zwei Figuren noch näher erläutert.

-4-    VPA  79 P 6583 EUR

Dabei zeigen jeweils stark vergrößert:

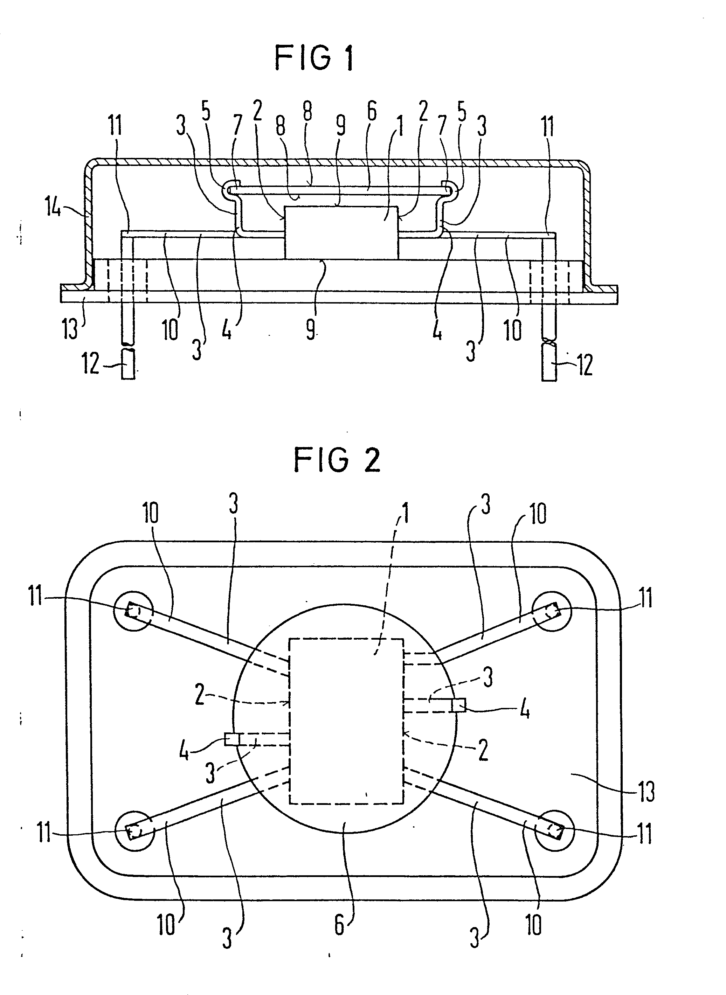

Fig. 1  in Seitenansicht und mit geschnitten dargestellter Gehäusekappe, den aus Resonator und IC-Bauelement zusammengesetzten Verbundbaustein in ein
zur Aufnahme des Resonators vorgesehenes Gehäuse
eingesetzt und

Fig. 2  eine Ansicht von oben auf den mit den Anschlußstiften einer Bodenplatte verbundenen, aus Resonator und IC-Bauelement bestehenden Verbundbaustein.

Im einzelnen ist den Figuren zu entnehmen, daß ein im
wesentlichen plattenförmiges, aus Kunststoff oder Keramik bestehendes prismatisches Gehäuse 1, das in seinem
Inneren und daher nicht sichtbare IC-Schaltkreise enthält, an seinen Längsseiten 2 jeweils eine Mehrzahl von
nebeneinander in einer Reihe aus dem IC-Gehäuse 1 herausgeführte, streifenförmige Anschlußelemente 3 aufweist.

Jeweils ein mittleres Anschlußelement 4 auf jeder der
beiden Längsseiten 2 des IC-Gehäuses 1 ist so abgewinkelt und endseitig so geformt, daß es je eine U-förmige
klipsartige Aufnahmekontur 5 bildet, in die ein z.B.
kreisscheibenförmiger Resonator 6 mit zwei einander
gegenüberliegenden Randstellen 7 eingefügt werden kann.
Die Schenkel der Kontur 5 stützen dabei den Resonator 6
rechtwinklig zu seinen großen Oberflächen 8 ab, während
die Basis der Kontur 5 im Zusammenwirken mit der gegenüberliegenden Basis den Resonator 6 in Richtung seiner
großen Oberflächen 8 fixiert.

Die Kontur 5 ist in die Anschlußelemente 4 des IC-Gehäuses 1 unmittelbar so gerichtet eingeformt, daß der Resonator 6 mit seinen großen Oberflächen 8 parallel zu den großen Oberflächen 9 des IC-Gehäuses 1 gehalten wird und dabei konzentrisch zu dem IC-Gehäuse 1 angeordnet ist.

Die vier äußeren Anschlußelemente 10 des IC-Gehäuses 1 sind parallel zu den großen Oberflächen 9 des IC-Gehäuses 1 und damit parallel zu den großen Oberflächen 8 des Resonators 6 ausgerichtet. Mit den Enden 11 der Anschlußelemente 10 ist das IC-Gehäuse 1 auf die Stirnseiten von Anschlußstiften 12 aufgesetzt, die ein Bodenstück 13 durchdringen und in diesem verankert sind. Durch Verlöten der Enden 11 mit den Anschlußstiften 12 wird das IC-Gehäuse 1 mit den Stiften 12 verbunden und damit am Bodenstück 13 befestigt.

Eine Gehäusekappe 14 umschließt den Resonator 6 und das IC-Gehäuse 1 und ist mit dem Bodenstück 13 verlötet , verklebt oder verschweißt.

Auf diese Weise ist der aus Resonator 6 und IC-Gehäuse 1 bestehende Verbundbaustein in einem gegenüber der Außenwelt abgeschlossenen Gehäuse betriebssicher angeordnet. Der Resonator 6 befindet sich dabei auf der vom Bodenstück 13 abgewandten Seite des IC-Gehäuses 1 in geringem Abstand von diesem, so daß er auch noch nach Herstellung der Verbindung zwischen IC-Gehäuse 1 und Bodenstück 13 in die als Halteklipse 5 wirksamen Konturen eingesetzt oder ausgewechselt werden kann.

Die mit den Anschlußstiften 12 verbundenen Anschlußelemente 10 sind in der Ebene parallel zu den großen Oberflächen 8 des IC-Gehäuses 1 leicht abgewinkelt, um sicherzustellen, daß die Enden 11 der Anschlußelemente 10 genau auf die Stirnseiten der Anschlußstifte 12
aufgesetzt werden können.

Durch Einstecken derjenigen Abschnitte der Anschlußstifte 12, die auf der vom IC-Gehäuse 1 abgewandten
Seite des Bodenstückes 13 aus diesem hervorstehen, in
Rasterbohrungen einer nicht dargestellten Leiterplatte
und durch Verlöten der Anschlußstifte 12 in diesen
Rasterbohrungen wird der aus dem Resonator 6 und dem
integrierten Schaltkreis, der in dem IC-Gehäuse 1 angeordnet ist, bestehende Oszillator betriebsbereit angeschlossen.

4 Patentansprüche
2 Figuren

Bezugszeichenliste

1   IC-Gehäuse

2   Längsseiten

3   Anschlußelemente

4   mittleres Anschlußelement

5   Aufnahmekontur

6   Resonator

7   Randstellen

8   große Oberflächen des Resonators

9   große Oberflächen des IC-Gehäuses

10   äußere Anschlußelemente

11   Enden der äußeren Anschlußelemente

12   Anschlußstifte

13   Bodenstück

14   Gehäusekappe

Patentansprüche

1. Elektrisches Bauelement mit wenigstens einem in integrierter Schaltungstechnik auf einem Substrat angeordneten Schaltkreis, der in einem im wesentlichen prismatischen Gehäuse angeordnet ist und bei dem an den Längsseiten des Gehäuses je eine Reihe von streifenförmigen Anschlußelementen, die mit dem Schaltkreis verbunden sind, aus dem Gehäuse herausgeführt sind, d a d u r c h   g e k e n n z e i c h n e t , daß je ein mittleres Anschlußelement (4) jeder Längsseite (2) derart abgewinkelt ausgebildet ist, daß ein mit im wesentlichen einander gegenüberliegenden Randstellen (7) in jeweils eine durch die Abwinkelungen gebildete U-förmige Aufnahmekontur (5) eingefügter plattenförmiger Resonator (6) in definiertem Abstand vom IC-Gehäuse (1) unmittelbar von den beiden Anschlußelementen (4) erfaßt und gehalten wird.

2. Elektrisches Bauelement nach Anspruch 1, d a d u r c h   g e k e n n z e i c h n e t , daß der Resonator (6) mit seinen großen Oberflächen (8) parallel zu den beiden großen Oberflächen (9) des ebenfalls plattenförmigen IC-Gehäuses (1) und konzentrisch zu diesem angeordnet ist.

3. Elektrisches Bauelement nach Anspruch 2, d a d u r c h   g e k e n n z e i c h n e t , daß zumindest einige der übrigen Anschlußelemente (10) parallel zu den großen Oberflächen (9) des IC-Gehäuses (1) ausgerichtet sind und daß das IC-Gehäuse (1) mit den Enden (11) dieser Anschlußelemente (10) auf die Stirnflächen von Anschlußstiften (12) aufgesetzt und mit diesen Anschlußstiften (12) verbunden ist, die rechtwinklig zu den großen Oberflächen (9) des IC-Gehäuses (1) ein Bodenstück (12) durchdringen und in diesem verankert sind.

4. Elektrisches Bauelement nach Anspruch 3, d a d u r c h
g e k e n n z e i c h n e t , daß der Resonator   (6)
auf der vom Bodenstück (13) abgewandten Seite des IC-Gehäuses (1) angeordnet ist.

5. Elektrisches Bauelement nach Anspruch 4, d a d u r c h
g e k e n n z e i c h n e t ,  daß mit dem Bodenstück (13)
eine den aus Resonator (6) und IC-Gehäuse (1) bestehenden
Verbundbaustein umhüllende hutförmige Gehäusekappe (14)
verbunden ist.

1/1

FIG 1

FIG 2